# EUROPEAN PATENT APPLICATION

(11) **EP 3 993 015 A1**
(43) Date of publication of application: **04.05.2022**
(21) Application number: 20832945.8
(22) Date of filing: 28.06.2020
(51) Int. Cl.: H01L 21/48

(54) **TAPERED MICRO-ELECTRONIC MICRO-CONNECTION DEEP-CAVITY WELDING CAPILLARY**

(30) Priority: 28.06.2019 CN 201921005924 U
(71) Applicant: Precision Rong Creation Technology Co., Ltd., Chengdu, Sichuan 610044 (CN)
(72) Inventor: YANG, Qiang, Chengdu, Sichuan 610044 (CN); XU, Bo, Chengdu, Sichuan 610044 (CN)
(74) Representative: De Lorenzo, Danilo
(86) International application number: PCT/CN2020/098398
(87) International publication number: WO 2020/259664

(57) **Abstract**

Disclosed is a micro-electronic micro-connection deep-cavity welding capillary, comprising a cylindrical capillary body, wherein one end of the capillary body is a frustoconical welding end, a stepped unfilled corner is provided on an end face of the welding end in the lengthwise direction of the capillary body, the remaining end face of the welding end is a welding end face, a spherical segment-shaped through groove is provided in the welding end face, a columnar first wire threading hole facing the interior of the capillary body is provided in the other end face of the capillary body in the lengthwise direction of the capillary body, a columnar second wire threading hole that is coaxial with the first wire threading hole is provided in a first side surface, not adjacent to the welding end face, of the unfilled corner, and a transition hole that connects the first wire threading hole to the second wire threading hole and has an isosceles-trapezoid-like cross section is further provided inside the capillary body. The present utility model is simple in structure, and rational in design, and in particular the transition hole matches the first wire threading hole and the second wire threading hole such that a gold wire can smoothly pass between the two holes, and the success rate of manual wire threading is increased.

## Description

The present application claims the priority to Chinese Patent Application No. 201921005924.5, titled "TAPERED MICRO-ELECTRONIC MICRO-CONNECTION DEEP-CAVITY WELDING CAPILLARY", filed with the China National Intellectual Property Administration on June 28, 2019, which is incorporated herein by reference in its entirety.

### FIELD

The present application relates to the technical field of micro-electronics, and in particular to a tapered micro-electronic micro-connection deep-cavity welding capillary and a processing method thereof.

### BACKGROUND

A light and flexible gold wire is used as a welding material by a deep-cavity welding capillary for micro-electronics, a diameter of the gold wire is generally 18µm to 25µm, and 25µm is commonly used. Usually, manual labor can only perform the threading operation with the help of a microscope. Generally, only one straight-through wire threading hole is defined on the capillary, and a depth-to-diameter ratio of the hole is generally large, so the processing requirement for the hole is high. In the existing deep-cavity welding capillary, it is difficult to avoid a burr during the processing in the wire threading hole, and the burr may affect the threading process. In addition, an existing shape structure of the capillary does not limit the position of the gold wire, so that it is difficult for the gold wire to be firmly mounted on a wire welding machine after threading out of the wire threading hole.

### SUMMARY

In order to solve the problem existing in the conventional technology, a tapered micro-electronic micro-connection deep-cavity welding capillary is provided according to the present application.

The technical solution adopted by the present application is as follows:
a tapered micro-electronic micro-connection deep-cavity welding capillary is provided, which includes a cylindrical capillary main body, an end of the capillary main body is a pyramid-shaped welding end, a stepped unfilled corner is defined on an end surface of the welding end in a length direction of the capillary main body, a remaining end surface of the welding end is a welding end surface, a spherical through hole is defined on the welding end surface, a length direction of the spherical through hole is consistent with a length direction of a corner edge of the unfilled corner, a columnar first wire threading hole facing an interior of the capillary main body is defined on another end surface of the capillary main body in the length direction of the capillary main body, a columnar second wire threading hole coaxial with the first wire threading hole is defined on a first side surface, not adjacent to the welding end surface, of the unfilled corner, a diameter and a depth of the second wire threading hole are respectively smaller than a diameter and a depth of the first wire threading hole, a transition hole connecting the first wire threading hole to the second wire threading hole and with an isosceles-trapezoid section is defined inside the capillary main body, one end of a long diameter of the transition hole is connected to one end of the first wire threading hole located inside the capillary, another end of a short diameter of the transition hole is connected to one end of the second wire threading hole located inside the capillary, an extended included angle between two waistlines of the transition hole is a, and a range of the a ranges is 20 degree< a <90 degrees.

A gold wire for welding is manually threaded into the capillary while shaking under a microscope. In the above technical solution, three holes with different diameters and depths are sequentially arranged in the capillary. The first wire threading hole has the largest depth-to-diameter ratio of all the three holes, a burr is inevitably formed on an inner wall of the first wire threading hole and at an edge inside the capillary, and part of the burr may be formed into the transition hole. In order to avoid the influence of the burr on the threading as much as possible, the diameter of the first wire threading hole is relatively large, so as to increase a shaking space of the gold wire in the first wire threading hole, and avoid the burr as much as possible.

A hole wall of the transition hole obliquely connects a hole wall of the first wire threading hole and a hole wall of the second wire threading hole, and an inclination angle is controlled smaller than 45 degrees. A normal direction of a force formed by a resistance of the hole wall of the transition hole to the gold wire and a force of the gold wire threading to the second wire threading hole always faces a central axis of the second wire threading hole, which plays a good guiding role in the threading of the gold wire. In addition, the inclination angle is controlled greater than 10 degrees, which reduces a contact stroke with a transition wall.

The diameter and the depth of the second wire threading hole are small, which mainly plays a guiding role in threading out the gold wire. The arrangement of the unfilled corner is configured to shorten the threading distance of the gold wire and reduce the processing difficulty. The gold wire is finally overlapped on the spherical through hole for welding.

Preferably, a side surface, adjacent to the welding end surface, of the unfilled corner is a second side surface, a V-shaped through hole is defined on the welding end surface located between the spherical through hole and the unfilled corner, a length direction of the V-shaped through hole is consistent with a length direction of the corner edge of the unfilled corner, a third wire threading hole extending to one side surface of the V-shaped through hole is obliquely defined on the second side surface, and a height of one end of the third wire threading hole located inside the V-shaped through hole is lower than a height of the spherical through hole.

In the above technical solution, in order to avoid excessive exposure of the gold wire to an outer side of the capillary, the third wire threading hole is defined for the gold wire to thread out, and the gold wire bypasses two ends of the V-shaped through hole and is overlapped on the spherical through hole.

Preferably, a bell mouth is defined at an end of the third wire threading hole located on the second side surface in an axis direction of the third wire threading hole.

In the above technical solution, a bending degree of the gold wire threading into the third wire threading hole is reduced, so as to prevent the gold wire from breaking.

Preferably, an inclined angle between a central axis of the third wire threading hole and the second side surface is 45 degrees.

In the above technical solution, the gold wire threads through the third wire threading hole and keeps parallel to the side wall corresponding to the V-shaped through hole, so as to reduce the bending degree of the gold wire and prevent the gold wire from breaking.

Preferably, a diameter ratio of the first wire threading hole to the second wire threading hole is 3:1, and a diameter ratio of the second wire threading hole and the third wire threading hole is 3:1.

Preferably, a depth-to-diameter ratio of the first wire threading hole is 38:1.

In the above technical solution, the stepped diameter ratio is relatively reasonable, which make the threading smooth.

The beneficial effects according to the present application are as follows:
(1) the first wire threading hole effectively makes the gold wire avoid the influence caused by the burr in the hole;
(2) the tapered micro-electronic micro-connection deep-cavity welding capillary provided according to the present application has a simple structure and a reasonable design. Especially, the cooperation of the transition hole with the first wire threading hole and the second wire threading hole enables the gold wire to smoothly transition between the first wire threading hole and the second wire threading hole,, which improves the success rate of manual threading;
(3) the unfilled corner plays a role of receiving between the second wire threading hole and the third wire threading hole, which avoids the unsmooth of the threading caused by excessive threading stroke; and
(4) the bell mouth is arranged on the side wall of the unfilled corner, which reduces the bending degree of the gold wire, so that the gold wire is not easy to break.

### BRIEF DESCRIPTION OF THE DRAWINGS

FIG. 1 is a schematic structural view of this embodiment; and
FIG. 2 is a partial enlarged view of FIG. 1.

**Reference numerals in the drawings:**

| | | | |
|---|---|---|---|
| 1 | capillary main body; | 11 | first wire threading hole; |
| 12 | second wire threading hole; | 13 | third wire threading hole; |
| 14 | transition hole; | 2 | welding end; |
| 211 | first side surface; | 212 | second side surface; |
| 221 | spherical through hole; | 222 | V-shaped through hole |

### DETAILED DESCRIPTION OF THE EMBODIMENTS

The embodiments of the present application will be described in detail below with reference to the drawings.

### Embodiment

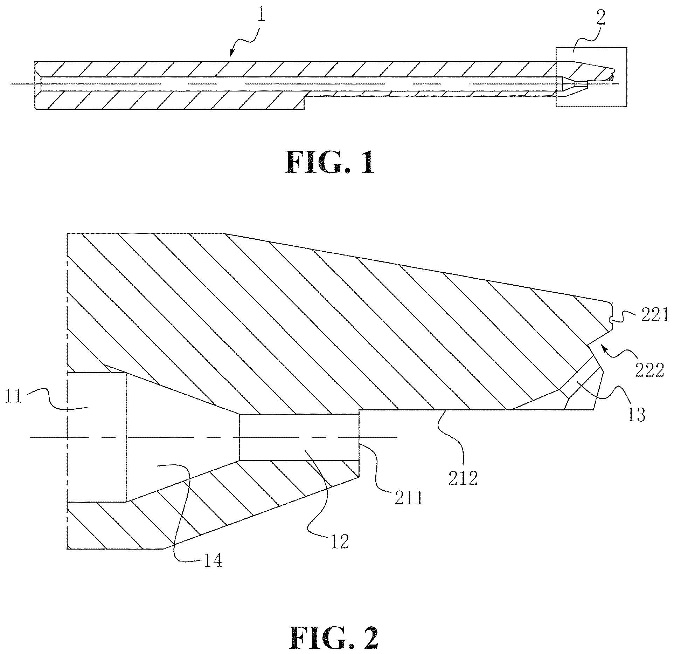

As shown in FIG. 1 and FIG. 2, a tapered micro-electronic micro-connection deep-cavity welding capillary is provided, which includes a cylindrical capillary main body 1, an end of the capillary main body 1 is a pyramid-shaped welding end 2, a stepped unfilled corner is defined on an end surface of the welding end 2 in a length direction of the capillary main body 1, a remaining end surface of the welding end 2 is a welding end surface, a spherical through hole 221 is defined on the welding end surface, a length direction of the spherical through hole 221 is consistent with a length direction of a corner edge of the unfilled corner, and the spherical through hole 221 is configured to stably mount the gold wire after it is threaded out.

A columnar first wire threading hole 11 facing an interior of the capillary main body 1 is defined on another end surface of the capillary main body 1 in the length direction of the capillary main body 1. In addition, the welding end 2 described above forms a stepped unfilled corner. One side surface of the step is a first side surface 211, and another side surface of the step is a second side surface 212. A columnar second wire threading hole 12 coaxial with the first wire threading hole 11 is defined on the first side surface 211, not adjacent to the welding end surface, of the unfilled corner, and a diameter and a depth of the second wire threading hole 12 are respectively smaller than a diameter and a depth of the first wire threading hole 11. Due to the different diameters, a connection portion may form an inner wall on an edge of the first wire threading hole 11 to block the threading of the gold wire if the first wire threading hole 11 is directly connected to the second wire threading hole 12 inside the capillary main body 1, so a transition connection is required between the first wire threading hole 11 and the second wire threading hole 12.

A section of a transition hole is similar to a cone, a transition hole 14 connecting the first wire threading hole 11 and the second wire threading hole 12 and having an isosceles-trapezoid cross section is defined inside the capillary main body 1, one end of a long diameter of the transition hole 14 is connected to one end of the first wire threading hole 11 located inside the capillary, another end of a short diameter of the transition hole 14 is connected to one end of the second wire threading hole 12 located inside the capillary, an extended included angle between two waistlines of the transition hole 14 is a, and a range of a is 20 degree< a <90 degrees.

In one of the embodiments, if the gold wire is directly overlapped on the welding end surface around the unfilled corner after threading out, the part of the gold wire which is threaded out is all exposed to the outside of the capillary, and is not conducive to the protection of the gold wire. A side surface, adjacent to the welding end surface, of the unfilled corner is the second side surface 212, a V-shaped through hole 222 is defined on the welding end surface located between the spherical through hole 221 and the unfilled corner, a length direction of the V-shaped through hole 222 is consistent with a length direction of the corner edge of the unfilled corner, a third wire threading hole 13 extending to one side surface of the V-shaped through hole is obliquely defined on the second side surface 212, and a height of one end of the third wire threading hole 13 located inside the V-shaped through hole is lower than a height of the spherical through hole 221. The part of the gold wire which is threaded out is then threaded into the third wire threading hole 13 and threaded out of the V-shaped through hole 222. The V-shaped through hole 222 plays a certain protective role for the gold wire, and the gold wire bypasses two ends of the V-shaped through hole 222 and is overlapped on the spherical through hole 221.

In one of the embodiments, a bell mouth is defined at an end of the third wire threading hole 13 located on the second side surface 212 in an axis direction of the third wire threading hole 13, which reduces a bending degree of the gold wire, prevents the gold wire from breaking, and ensures the strength of the gold wire.

In one of the embodiments, an included angle between a central axis of the third wire threading hole 13 and the second side surface 212 is 45 degrees.

Further, a diameter ratio of the first wire threading hole 11 to the second wire threading hole 12 is 3:1, and a diameter ratio of the second wire threading hole 12 and the third wire threading hole 13 is 3:1, the first wire threading hole 11, the second wire threading hole 12 and the third wire threading hole 13 are stepped to form a guiding role on the gold wire.

Furthermore, a depth-to-diameter ratio of the first wire threading hole 11 is 38:1, and the depth-to-diameter ratio is the ratio of the depth to the diameter. The depth-to-diameter ratio is relatively large and the diameter is moderate, so as to avoid the bending and breaking of the gold wire as it encounters the burr in the hole. In addition, the hole is processed by electric spark to reach a higher accuracy.

Only some embodiments of the present application are described specifically and in detail in the above content, which should not be taken as limitation to the scope of the present application. It should be noted that for those skilled in the art, without departing from the concept of the present application, several modifications and improvements can be made, and these all fall within the protection scope of the present application.

## Claims

1. A tapered micro-electronic micro-connection deep-cavity welding capillary, comprising a cylindrical capillary main body, wherein an end of the capillary main body is a pyramid-shaped welding end, a stepped unfilled corner is defined on an end surface of the welding end in a length direction of the capillary main body, a remaining end surface of the welding end is a welding end surface, a spherical through hole is defined on the welding end surface, a length direction of the spherical through hole is consistent with a length direction of a corner edge of the unfilled corner, a columnar first wire threading hole facing an interior of the capillary main body is defined on another end surface of the capillary main body in the length direction of the capillary main body, a columnar second wire threading hole coaxial with the first wire threading hole is defined on a first side surface, not adjacent to the welding end surface, of the unfilled corner, a diameter and a depth of the second wire threading hole are respectively smaller than a diameter and a depth of the first wire threading hole, a transition hole connecting the first wire threading hole and the second wire threading hole and with an isosceles-trapezoid section is defined inside the capillary main body, one end of a long diameter of the transition hole is connected to one end of the first wire threading hole located inside the capillary, another end of a short diameter of the transition hole is connected to one end of the second wire threading hole located inside the capillary, an extended included angle between two waistlines of the transition hole is a, and a range of a is 20 degree< a <90 degrees.

2. The tapered micro-electronic micro-connection deep-cavity welding capillary according to claim 1, wherein a side surface, adjacent to the welding end surface, of the unfilled corner is a second side surface, a V-shaped through hole is defined on the welding end surface located between the spherical through hole and the unfilled corner, a length direction of the V-shaped through hole is consistent with the a length direction of the corner edge of the unfilled corner, a third wire threading hole extending to one side surface of the V-shaped through hole is obliquely defined on the second side surface, and a height of one end of the third wire threading hole located inside the V-shaped through hole is lower than a height of the spherical through hole.

3. The tapered micro-electronic micro-connection deep-cavity welding capillary according to claim 2, wherein a bell mouth is defined at an end of the third wire threading hole located on the second side surface in an axis direction of the third wire threading hole.

4. The tapered micro-electronic micro-connection deep-cavity welding capillary according to claim 2, wherein an inclined angle between a central axis of the third wire threading hole and the second side surface is 45 degrees.

5. The tapered micro-electronic micro-connection deep-cavity welding capillary according to claim 2, wherein a diameter ratio of the first wire threading hole to the second wire threading hole is 3:1, and a diameter ratio of the second wire threading hole and the third wire threading hole is 3:1.

6. The tapered micro-electronic micro-connection deep-cavity welding capillary according to claim 1, wherein a depth-to-diameter ratio of the first wire threading hole is 38:1.
